(19) Europäisches Patentamt / European Patent Office / Office européen des brevets

(11) **EP 4 593 085 A1**

(12) **EUROPEAN PATENT APPLICATION**
published in accordance with Art. 153(4) EPC

(43) Date of publication:
**30.07.2025 Bulletin 2025/31**

(21) Application number: **23867035.0**

(22) Date of filing: **27.06.2023**

(51) International Patent Classification (IPC):
**H01L 29/06** (2006.01)    **H01L 29/739** (2006.01)

(52) Cooperative Patent Classification (CPC):
Y02B 70/10

(86) International application number:
**PCT/CN2023/102567**

(87) International publication number:
**WO 2024/060740 (28.03.2024 Gazette 2024/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.09.2022 CN 202211166946**

(71) Applicant: **Suzhou Watech Electronics Co., Ltd.**
**Suzhou, Jiangsu 215125 (CN)**

(72) Inventors:
• **QI, Jinwei**
  **Suzhou, Jiangsu 215000 (CN)**
• **LIU, Qian**
  **Suzhou, Jiangsu 215000 (CN)**
• **ZHANG, Yaohui**
  **Suzhou, Jiangsu 215000 (CN)**

(74) Representative: **Michalski Hüttermann & Partner Patentanwälte mbB**
**Kaistraße 16A**
**40221 Düsseldorf (DE)**

(54) **IGBT DEVICE**

(57)    Provided in the embodiments of the present application is an IGBT device. The IGBT device comprises a collector electrode; an electric-field termination layer formed on the collector electrode; an electric-field transition layer formed on the electric-field termination layer; a drift region formed on the electric-field transition layer; a plurality of column regions formed in the drift region; and a well region formed above the drift region, wherein the doping concentration of the electric-field transition layer is less than the doping concentration of the electric-field termination layer, and the drift region and the electric-field transition layer can be subjected to an electrical conductivity modulation effect to accumulate few charge carriers. When the IGBT device is turned off, the electric-field transition layer is completely exhausted, an electric field is reduced at the electric-field transition layer and is reduced to 0 at the electric-field termination layer, and the electric field is smoothly reduced from top to bottom at the junction of the electric-field transition layer and the electric-field termination layer. The embodiments of the present application solve the technical problems of conventional SJ-IGBT devices having relatively great turn-off loss in the turn-off process and the stability of the devices being insufficient due to the abrupt change in electric fields.

Fig. 4

**Description**

TECHNICAL FIELD

The present disclosure relates to the technical field of power devices, and more particularly to an IGBT device.

BACKGROUND

As a fully controlled voltage-driven power semiconductor device, the Insulated Gate Bipolar Transistor (IGBT) is widely used in the field of high-power power conversion. IGBT device comprises a Bipolar Junction Transistor (BJT) and a Metal Oxide Semiconductor (MOS), and have the advantages of high input impedance of Metal-Oxide-Semiconductor Field-Effect Transistor (MOSFET) and low conduction voltage drop of Giant Transistor (GTR). It is adapted for converter systems with DC voltages of 600V and above, such as AC motors, frequency converters, switching power supplies, lighting circuits, traction drives, and other fields.

Super-Junction technology provides a new technical solution to improve the performance of power devices. Using the staggered arrangement of N-type regions and P-type regions, the super-junction structure can flatten the electrical field in the drift region, effectively reduce the thickness of the drift region of the power device, and achieve the purpose of increasing the breakdown voltage of the device.

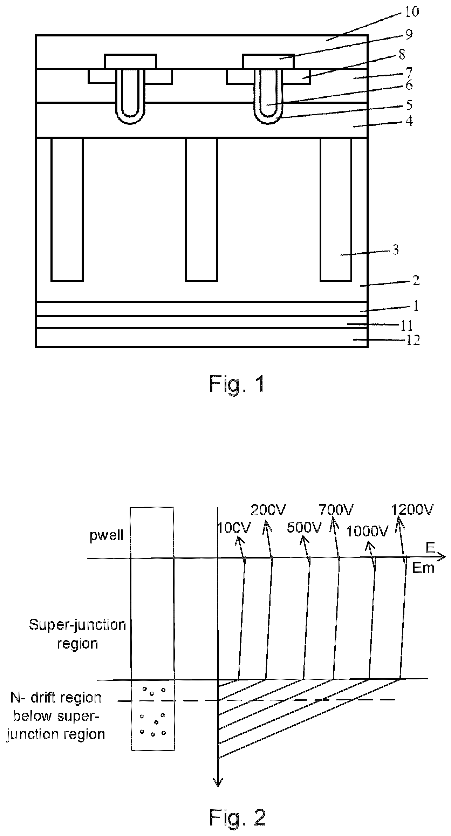

In the conventional SJ-IGBT device, as shown in Fig. 1, 1 is a P- collector region, 2 is a N-drift region, 3 is a P-type super-junction region, 4 is a N-type second epitaxy, 5 is a gate oxide layer, 6 is a gate electrode, 7 is a Pwell, 8 is a N+ emitter electrode, 9 is a dielectric layer, 10 is an emitter electrode metal, 11 is a P+ collector electrode, and 12 is a collector electrode metal. In the conventional super-junction IGBT device, the part of the N- drift region 2 below the P-type super-junction region stores a large number of holes, resulting in generating the tail current, and the tail current leads to a large turn-off loss.

Fig. 2 is a schematic diagram of the electrical field change formed by applying different voltages to the emitter electrode and the collector electrode of the same conventional SJ-IGBT device shown in Fig. 1 when turned off. The vertical axis is the distance from Pwell 7 to the N- drift region 2 in Fig. 1, and the horizontal axis is the actual electrical field intensity formed by applying different voltages to the emitter electrode and the collector electrode of the conventional SJ-IGBT device when turned off. In a case where the conventional SJ-IGBT device is turned off, when a relatively low voltage such as 200 V is applied to the emitter electrode and the collector electrode, the electrical field terminates in the N-drift region 2, and the dotted line position is the position where the electrical field terminates. In this way, the part of the N- drift region 2 above the dotted line is all depleted, but the part of the N-drift region 2 below the dotted line still has holes, and thus the tail current is generated. In Fig. 2, the circles are the holes. It can be seen that in a case where the conventional SJ-IGBT device is turned off, the smaller voltage applied to the emitter electrode and the collector electrode, the greater tail current and the greater turning-off loss.

Compared with the conventional high-voltage IGBT, the SJ-IGBT device, as a new generation of high-speed IGBT device, has better device merits. Lower conduction voltage drop, lower switching loss, and higher switching speed make the device have great application value, and the excellent electrical performance has been verified by experiments.

Although the performance of the SJ-IGBT device has been greatly improved, due to the conductance modulation effect of bipolar devices, the device still has the problem of tail current during the turn-off process, resulting in large turn-off energy loss of the device.

Therefore, the sudden change of electrical field in the turn-off process of conventional SJ-IGBT devices leads to insufficient stability, which is a technical problem that one skilled in the art urgently needs to solve.

The above information disclosed in the background is merely for enhancing the understanding of the background of the present disclosure, and therefore, it may contain information that has not formed prior art known to one having ordinary skill in the art.

SUMMARY

The embodiment of the present disclosure provides an IGBT device to solve the technical problems of large turn-off loss and insufficient stability caused by sudden change of the electrical field in the turn-off process of the conventional SJ-IGBT device.

The embodiment of the present disclosure provides an IGBT device comprising:

a collector electrode of a first doping type;
an electrical field termination layer of a second doping type, formed above the collector electrode;
an electrical field transition layer of the second doping type, formed above the electrical field termination layer;
a drift region of the second doping type, formed above the electrical field transition layer; and

a plurality of pillar regions of the first doping type, formed inside the drift region and arranged at intervals along a vertical withstand voltage direction;

a well region of the first doping type, formed above the drift region.

A doping concentration of the electrical field transition layer is less than a doping concentration of the electrical field termination layer. The drift region and the electrical field transition layer accumulate minority carriers by conductance modulation effect respectively. In a case where the IGBT device is turned off, the electrical field transition layer is completely depleted, the electrical field decreases at the electrical field transition layer and decreases to 0 at the electrical field termination layer, and the electrical field decreases smoothly from top to bottom at an interface position between the electrical field transition layer and the electrical field termination layer.

With the above technical solution, the embodiment of the present disclosure has the following technical effects: The doping concentration of the electrical field transition layer is less than the doping concentration of the electrical field termination layer, and only two of the drift region, the electrical field transition layer and the electrical field termination layer can accumulate minority carriers by conductance modulation effect respectively. However, the electrical field termination layer cannot have the conductance modulation effect and cannot accumulate minority carriers. That is, the doping concentration of the electrical field transition layer is low, and the doping concentration is low enough to accumulate minority carriers by conductance modulation effect. The doping concentration of the electrical field termination layer is high, and the doping concentration is high enough that the conductance modulation effect hardly occurs and minority carriers are hardly accumulated. When the channel of the IGBT device is formed, the minority carriers are injected from the collector electrode into the drift region and the electrical field transition layer, and the conductance modulation effect occurs in the drift region and the electrical field transition layer, the resistances of the drift region and the electrical field transition layer are reduced, and thus the IGBT device has a low on-state voltage during turned on. That is, the resistances of the drift region and the electrical field transition layer are reduced by the conductance modulation effect. Because of the conductance modulation effect, in a case where the IGBT device is turned on, the collector electrode injects a large number of minority carriers into the drift region and the electrical field transition layer for accumulation. In a case where the IGBT device is turned off, the electrical field rapidly broadens downward, and the minority carriers stored in the drift region and the electrical field transition layer are quickly depleted. That is, the electrical field transition layer is completely depleted. However, due to the high doping concentration, the electrical field termination layer hardly stores minority carriers, so the tail current becomes very small. In order to completely deplete the minority carriers accumulated in the electrical field transition layer as soon as possible, it is necessary to arrange the thickness of the electrical field transition layer to be smaller. Since the thickness of the electrical field transition layer is small, the number of minority carriers accumulated in the electrical field transition layer is small, and the minority carriers can be depleted in the electrical field transition layer in a short time. Therefore, no tail current is generated, so that the turn-off energy loss of the IGBT device is small. Also, the electrical field smoothly decreases from top to bottom at the interface position between the electrical field transition layer and the electrical field termination layer, which prevents the sudden change of the electrical field at the interface position between the electrical field transition layer and the electrical field termination layer, and makes the stability of the IGBT device higher.

BRIEF DESCRIPTION OF THE DRAWINGS

The accompanying drawings described herein are intended to provide a further understanding of the present disclosure, and constitute a part of the present disclosure, and the schematic embodiments of the present disclosure and the description thereof are intended to explain the present disclosure, and do not constitute an undue limitation of the present disclosure. In the drawings:

Fig. 1 is a schematic structural diagram of a conventional SJ-IGBT device in the background.
Fig. 2 is a schematic diagram of the electrical field change formed by different voltages of the emitter electrode and the collector electrode of the same conventional SJ-IGBT device shown in Fig. 1 when turned off.
Fig. 3 is a schematic structure diagram of an IGBT device according to an embodiment of the present disclosure.
Fig. 4 is a schematic diagram of the electrical field change formed by different voltages of the emitter electrode and the collector electrode of the IGBT device shown in Fig. 3 when turned off, and the electrical field decreases smoothly from top to bottom at the interface position between the electrical field transition layer and the electrical field termination layer.

REFERENCES IN THE DRAWINGS:

In the background:

P- collector region 1, N- drift region 2, P-type super-junction region 3, second epitaxy 4, gate oxide layer 5, gate electrode 6, Pwell 7, N+ emitter electrode 8, dielectric layer 9, emitter electrode metal 10, P+ collector electrode 11, collector electrode metal 12;

In the embodiment of the present disclosure:

electrical field transition layer 1, drift region 2, pillar region 3, epitaxial layer 4 of second doping type, gate oxide layer 5, gate electrode 6, well region 7, emitter electrode 8, dielectric layer 9, emitter electrode metal 10, electrical field termination layer 11, collector electrode 12, collector electrode metal 13.

## DETAILED DESCRIPTION OF THE EMBODIMENTS

In order to make the technical solutions and advantages in the embodiments of the present disclosure more clear, the exemplary embodiments of the present disclosure will be described in further detail below with reference to the accompanying drawings, and it is obvious that the described embodiments are only a part of the embodiments of the present disclosure, and are not exhaustive of all the embodiments. It should be noted that the embodiments and features in the embodiments in the present disclosure may be combined with each other as long as there is no conflict.

Embodiment One

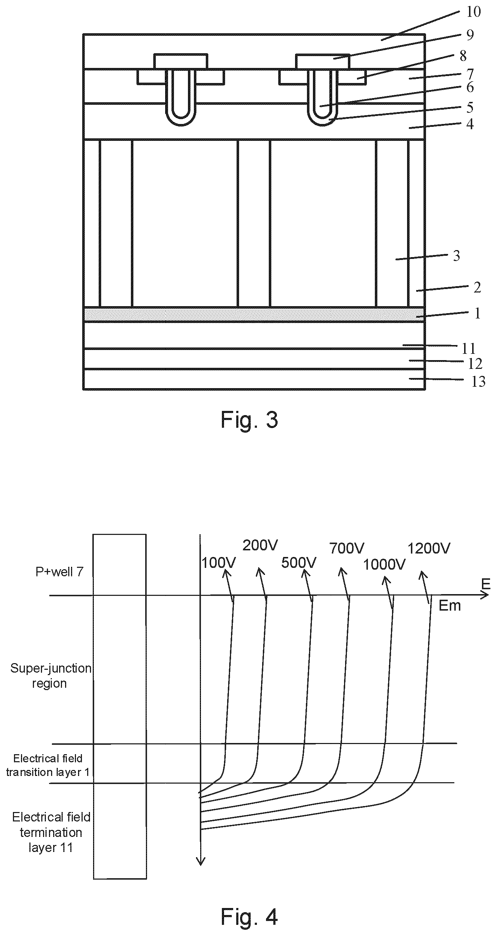

As shown in Fig. 3, an IGBT device according to an embodiment of the present disclosure comprises:

a collector electrode 12 of a first doping type;
an electrical field termination layer 11 of a second doping type, formed above the collector electrode;
an electrical field transition layer 1 of the second doping type, formed above the electrical field termination layer;
a drift region 2 of the second doping type, formed above the electrical field transition layer; and
a plurality of pillar regions 3 of the first doping type, formed inside the drift region and arranged at intervals along a vertical withstand voltage direction;
a well region 7 of the first doping type, formed above the drift region;
where a doping concentration of the electrical field transition layer is less than a doping concentration of the electrical field termination layer, and the drift region and the electrical field transition layer accumulate minority carriers by conductance modulation effect respectively. In a case where the IGBT device is turned off, the electrical field transition layer is completely depleted, the electrical field decreases at the electrical field transition layer and decreases to 0 at the electrical field termination layer, and the electrical field decreases smoothly from top to bottom at an interface position between the electrical field transition layer and the electrical field termination layer.

In the IGBT device according to the embodiment, the doping concentration of the electrical field transition layer is less than the doping concentration of the electrical field termination layer, and only two of the drift region, the electrical field transition layer and the electrical field termination layer can accumulate minority carriers by conductance modulation effect respectively. However, the electrical field termination layer cannot have the conductance modulation effect and cannot accumulate minority carriers. That is, the doping concentration of the electrical field transition layer is low, and the doping concentration is low enough to accumulate minority carriers by conductance modulation effect. The doping concentration of the electrical field termination layer is high, and the doping concentration is enough high that the conductance modulation effect hardly occurs and minority carriers are hardly accumulated. When the channel of the IGBT device is formed, the minority carriers are injected from the collector electrode into the drift region and the electrical field transition layer, and the conductance modulation effect occurs in the drift region and the electrical field transition layer, the resistances of the drift region and the electrical field transition layer are reduced, and thus the IGBT device has a low on-state voltage during turned on. That is, the resistances of the drift region and the electrical field transition layer are reduced by the conductance modulation effect. Because of the conductance modulation effect, in a case where the IGBT device is turned on, the collector electrode injects a large number of minority carriers into the drift region and the electrical field transition layer for accumulation. In a case where the IGBT device is turned off, the electrical field rapidly broadens downward, and the minority carriers stored in the drift region and the electrical field transition layer are quickly depleted, that is, the electrical field transition layer is completely depleted. However, due to the high doping concentration, the electrical field termination layer hardly stores minority carriers, so the tail current becomes very small. In order to completely deplete the minority carriers accumulated in the electrical field transition layer as soon as possible, it is necessary to arrange the thickness of the electrical field transition layer smaller. Since the thickness of the electrical field transition layer is small, the number of minority carriers accumulated in the electrical field transition layer is small, and the minority carriers can be depleted in the electrical field transition layer in a short time. Therefore, no tail current is generated, so that the turn-off energy loss of the IGBT device is small. Also, the electrical field smoothly decreases from top to bottom at the interface position between the electrical field transition layer and the electrical field termination layer, which prevents the sudden change of the electrical field at the interface position between the electrical field transition layer and the electrical field termination layer, and makes the stability of the IGBT device higher. The rate of electrical field drop corresponds to the rate of current change when the IGBT device is turned off. The faster the electrical field drops, the greater the rate of current change, that is, the greater the rate of current change di/dt, resulting in a larger overshoot voltage of the device, which can lead to the damage of the device.

The electrical field decreases smoothly from top to bottom at the interface position of the electrical field transition layer and the electrical field termination layer, and the smooth decrease is quantified as follows:

The slope of the electrical field on the lower surface of the electrical field transition layer $T_{\text{transition layer lower surface}}$ and the slope of the electrical field on the upper surface of the electrical field termination layer $T_{\text{termination layer upper surface}}$ satisfy the following relationship:

$$(T_{\text{termination layer upper surface}} - T_{\text{transition layer lower surface}}) / T_{\text{termination layer upper surface}} \leq 10\%.$$

The electrical field decreases slowly in the electrical field transition layer and decreases rapidly in the electrical field termination layer. Therefore, the interface position between the electrical field transition layer and the electrical field termination layer is the position where the electrical field changes greatly. Therefore, by controlling the change of the electrical field at the interface position between the electrical field transition layer and the electrical field termination layer, the electrical field at the interface position between the electrical field transition layer and the electrical field termination layer does not suddenly change but smoothly decreases.

In order to realize the smooth reduction of the electrical field from top to bottom at the interface position between the electrical field transition layer and the electrical field termination layer, the realizing method is to control the doping concentration at the interface position between the electrical field transition layer and the electrical field termination layer. The doping concentration of the lower surface of the electrical field transition layer $R_{\text{transition layer lower surface}}$ and the doping concentration of the upper surface of the electrical field termination layer $R_{\text{termination layer lower surface}}$ satisfy the following relationship:

$$(R_{\text{termination layer upper surface}} - R_{\text{transition layer lower surface}}) / R_{\text{termination layer upper surface}} \leq 10\%.$$

In this way, the difference in doping concentration between the lower surface of the electrical field transition layer and the lower surface of the electrical field termination layer is small.

In implementation, the doping concentration of the electrical field transition layer gradually increases from the upper surface to the lower surface of the electrical field transition layer.

As described above, as approaching the lower surface of the electrical field transition layer, the doping concentration of the electrical field transition layer becomes larger, and the difference between the doping concentration of the electrical field transition layer and the doping concentration of the upper surface of the electrical field termination layer becomes smaller.

In an optional embodiment, the doping concentration of the electrical field transition layer gradually increases from the upper surface to the lower surface of the electrical field transition layer, and the doping of the electrical field transition layer is linearly changing doping.

In another optional embodiment, the doping concentration of the electrical field transition layer gradually increases from the upper surface to the lower surface of the electrical field transition layer, and the doping of the electrical field transition layer is a semi-normal distribution. The curve of normal distribution is bell-shaped, low at two ends, high in the middle, and symmetrical in left and right. The curve of a semi-normal distribution is a half curve of the normal distribution. In this way, the slope of the doping concentration of the electrical field transition layer increases from the upper surface to the lower surface of the electrical field transition layer, and the slope reaches the maximum at the lower surface of the electrical field transition layer. The doping concentration in the electrical field transition layer increases smoothly, and the doping concentration at the interface position between the lower surface of the electrical field transition layer and the upper surface of the electrical field termination layer also increases smoothly.

In implementation, the total charge of the electrical field transition layer $Q_{\text{total}}$ is less than or equal to k% $\times$ Ec/Es; where k% is the percentage of electrical field strength to critical breakdown electrical field strength under the condition of minimum preset working voltage of the IGBT device, Ec is the critical breakdown field strength of the IGBT device with a Si substrate, and $\varepsilon$s is the dielectric constant of the IGBT device with the Si substrate.

In order to completely deplete the minority carriers accumulated in the electrical field transition layer as soon as possible, the total charge of the electrical field transition layer $Q_{\text{total}}$ needs to meet the preset condition that $Q_{\text{total}}$ is less than k% $\times$ Ec/$\varepsilon$s, which can be depleted inside the electrical field transition layer in a short time. Therefore, no tail current is generated, so the turn-off energy loss of the IGBT device is small.

In implementation, the value range of k% is greater than or equal to 10% and less than or equal to 80%.

In an optional embodiment, the first doping type is N-type doping, and the second doping type is P-type doping. In this case, the minority carriers are electrons.

In another optional embodiment, the first doping type is P-type doping, and the second doping type is N-type doping. In this case, the minority carriers are holes. The IGBT device, according to the embodiment of the present disclosure, is adapted for the case where the first doping type is P-type doping and the second doping type is N-type doping. Specifically, the electrical field transition layer 1 is N-type lightly doped, the electrical field termination layer 11 is N-type heavily doped, the drift region 2 is N-type lightly doped, the epitaxial layer 4 is N-type lightly doped, the emitter electrode 8 is N-type heavily doped, and the collector electrode 12 is P-type heavily doped.

In the implementation, when the doping of the electrical field transition layer is linearly changing doping, the total charge of the electrical field transition layer $Q_{total}$ and the thickness of the electrical field transition layer Wp satisfy the following relationship:

$$Q_{total} = q \times G \times Wp^2/2;$$

where q is the charge amount of one single electron and G is the slope of linearly changing doping.

In this way, under the condition that $Q_{total} < k\% \times Ec/\varepsilon s$, a specific value of $Q_{total}$ can be determined first, and then the relationship between the slope G of linearly changing doping and the thickness Wp of the electrical field transition layer can be determined according to $Q_{total} = q \times G \times Wp^2/2$. Finally, by selecting multiple thickness values of the electrical field transition layer in simulation, the IGBT device with good effect is selected.

The following describes the preset condition that the total charge of the electrical field transition layer $Q_{total}$ satisfies from the physical principle:

The electrical field intensity E(x) and the total charge Q(x) of the electrical field transition layer satisfy the following relationship:

$$-dE/dx = -Q(x)/\varepsilon s;$$

that is

$$E(x) = \int Q(x)/\varepsilon s \times d(x); \text{ Formula 1}$$

where $\varepsilon s$ is the dielectric constant of Si, and d(x) is the distance between the upper surface and the lower surface of the electrical field transition layer along the electrical field strength direction. Formula 1 is the universal formula of electrical field intensity and total charge of the electrical field transition layer.

The present disclosure aims to realize that when the IGBT device is turned off under different voltage conditions, the current tail is very small, or even no current tail exists. It is assumed that the minimum preset working voltage of IGBT device is k% × BV, BV is the breakdown voltage of IGBT device, and the maximum field strength Em corresponding to the minimum preset working voltage of IGBT device is approximately k% × Ec, k% is the percentage of the electrical field strength to the critical breakdown electrical field strength under the minimum preset working voltage of the IGBT device, that is, the electrical field strength on the upper surface of transition layer is k% × Ec, Ec is the critical breakdown field strength of Si, and $\varepsilon s$ is the dielectric constant of Si. The critical condition is that the electrical field strength on the lower surface of the electrical field transition layer is equal to 0. Correspondingly, the total charge of the electrical field transition layer under critical conditions is $Q_{critical}$. For the specific case where the critical condition is that the electrical field strength of the lower surface of the electrical field transition layer is equal to 0, Formula 1 can be simplified as:

$$k\% \times Ec = Q_{critical} / \varepsilon s; \text{ Formula 2};$$

That is, it can be deduced: $Q_{critical} = k\% \times Ec/\varepsilon s$; where $\varepsilon s$ is the dielectric constant of Si.

Therefore, the total charge of the electrical field transition layer $Q_{total}$ should be less than $Q_{critical}$, that is, $Q_{total} < k\% \times Ec/\varepsilon s$.

$Q_{total} < k\% \times Ec/\varepsilon s$, is the applicable relationship between the electrical field strength and the total charge of the electrical field transition layer, in a case where the minimum preset working voltage of IGBT device is k% × BV and the critical condition is that the electrical field strength on the lower surface of the electrical field transition layer is equal to 0. In this specific case, it is not only adapted to the case where the doping of the electrical field transition layer is uniformly doped, but also to the case where the doping of the electrical field transition layer is non-uniformly doped. Thus, in the specific case where the minimum preset working voltage of the IGBT device is k% $\times$ BV and the critical condition is that the electrical field strength of the lower surface of the electrical field transition layer is equal to 0, the requirement for the total charge of the electrical field transition layer $Q_{total}$ is determined.

In implementation, as shown in Fig. 3, the lower end of the pillar region 3 and the lower end of the drift region 2 are even, and the lower end of the pillar region 3 and the lower end of the drift region 2 are respectively connected to the upper surface of the electrical field transition layer 1.

In implementation, as shown in Fig. 3, the IGBT device further comprises:

an epitaxial layer 4 of the second doping type formed above the drift region 2 and below the well region 7;
where the upper end of the pillar region 3 and the upper end of the drift region 2 are even, and the upper end of the pillar region 3 and the upper end of the drift region 2 are respectively connected to the lower surface of the epitaxial layer 4.

By providing the epitaxial layer 4, the upper end, the lower end, the left end, and the right end of the pillar region 3 are all the second doping type regions. That is, the floating arrangement of the pillar region 3 is realized. With the pillar region floating, the minority carriers injected into the pillar region by the collector electrode are stored more, so that the on-state voltage drop in the on-state is lower.

In implementation, as shown in Fig. 3, the IGBT device further comprises:

a collector electrode metal 13, formed below the collector electrode 12;
a gate trench, extended downward from an upper surface of the well region 7 into the epitaxial layer 4;
a gate oxide layer 5, formed inside the gate trench;
a gate electrode 6, formed on the gate oxide layer 5 and even with an upper surface of the well region 7;
an emitter electrode 8 of the second doping type, downward from the upper surface of the well region 7, and the depth of the emitter electrode 8 is shallower than the well region 7;
a dielectric layer 9, covering the gate electrode and the gate oxide layer and partially covering the emitter electrode 8; and
an emitter electrode metal 10, formed above the emitter electrode 8 and the dielectric layer 9; where the dielectric layer 9 insulates the gate electrode and the emitter electrode metal 10.

That is, the IGBT device is a trench gate super-junction IGBT device.

Fig. 4 is a schematic diagram of the electrical field change formed by different voltages of the emitter electrode and the collector electrode of the IGBT device shown in Fig. 3 when turned off, and the electrical field decreases smoothly from top to bottom at the interface position between the electrical field transition layer and the electrical field termination layer. The vertical axis is the distance from the well region 7 to the drift region 2 in Fig. 3. The horizontal axis shows the actual electrical field distribution, when the emitter electrode and the collector electrode are under the increasing voltage and when the IGBT device shown in Fig. 3 is turned off.

As shown in Figs. 3 and 4, when the IGBT device is turned off, the electrical field rapidly broadens downward, and the minority carriers stored in the drift region and transition layer are quickly depleted. However, due to the high doping concentration, the electrical field termination layer hardly stores minority carriers, so the tail current becomes very small.

In the disclosure, the electrical field transition layer is thin, and it can be seen from the electrical field distribution that the electrical field of the same device finally terminates at the electrical field termination layer under different voltage conditions, as shown in Fig. 4. Therefore, regardless of the voltage condition under which the IGBT device is turned off, the current tail is very small or even non-existent.

However, under different voltage conditions, the electrical field of conventional super-junction devices is cut off at different positions in the drift region, as shown in Fig. 2. When the voltage is small, the non-depleted drift region is wider. Therefore, the non-depleted drift region will cause current tailing when turned off, and the higher the voltage, the smaller the current tailing. Therefore, compared with the conventional super-junction structure, the IGBT device of the embodiment of the present disclosure can be used at both high voltage and low voltage, and even under low voltage conditions, there is no tail current, and the turn-off loss is small.

In the present disclosure, the doping concentration of the electrical field termination layer is from $10^{17}/cm^3$ to $5\times10^{17}/cm^3$, that is, the doping concentration of the electrical field termination layer is sufficiently high. The electrical field termination layer does not generate the conductance modulation effect. That is, minority carriers do not accumulate inside the electrical field termination layer. The function of the electrical field termination layer is only that the electrical field linearly decreases to zero in the electrical field termination layer to realize the termination of the electrical field. That is, the electrical field termination layer only plays a role in quickly terminating the electrical field.

In the present disclosure, the doping concentration of the electrical field transition layer is in the magnitude of

$10^{13}/cm^3$ to $10^{15}/cm^3$, so that the electrical field transition layer can generate the conductance modulation effect and can also withstand the partial breakdown voltage.

Specifically, the electrical field terminates in the electrical field termination layer, and the position of the electrical field termination in the electrical field termination layer and the lower surface of the electrical field termination layer have a preset distance to prevent breakdown.

After the electrical field is reduced by the electrical field transition layer, the linear rapid decrease in the electrical field termination layer to realize the termination of the electrical field.

Specifically, the thickness of the electrical field transition layer is less than the thickness of the electrical field termination layer.

In this way, the IGBT device is turned off, and the electrical field transition layer is completely depleted, and thus, the thickness of the electrical field transition layer is required to be thin. The thickness of the electrical field termination layer needs to prevent breakdown, and the required thickness is larger. Therefore, the thickness of the electrical field transition layer is less than the thickness of the electrical field termination layer.

Specifically, the doping concentration of the electrical field transition layer is at least 1-1.5 magnitudes lower than the doping concentration of the electrical field termination layer.

Specifically, the doping concentration of the epitaxial layer is less than the doping concentration of the drift region, and the doping concentration of the epitaxial layer is slightly lower than the doping concentration of the drift region.

Specifically, the doping concentration of the drift region is in the magnitude of $10^{14}/cm^3$ to $10^{15}/cm^3$. The doping concentration of the pillar region and the doping concentration of the drift region are on the same magnitude. The charge amount in the drift region and the pillar region should be equal.

That is, the drift region and the pillar region should achieve charge balance.

The preparation process of the IGBT device is as follows:

Step S11: growing a first epitaxy on a silicon substrate;

Step S12: digging a deep groove corresponding to the pillar region and filling the deep groove corresponding to the pillar region;

Step S13: growing a second epitaxy;

Step S14: digging a trench corresponding to the gate electrode, growing a gate oxide layer in the trench corresponding to the gate electrode, and padding and planishing a polysilicon on the gate oxide layer. At this point, the gate electrode is finished;

Step S15: performing ion implantation or thermal diffusion on the upper surface of the second epitaxy to form a well region 7, where the depth of the well region 7 is shallower than the trench corresponding to the gate electrode;

Step S16: performing ion implantation or thermal diffusion on the upper surface of the second epitaxy to form an emitter electrode 8, where the depth of the emitter electrode 8 is shallower than the well region 7;

Step S17: forming a dielectric layer 9; and

Step S18: forming an emitter electrode metal 10.

At this point, the front process of the IGBT device is completed.

Thereafter, the device is turned over, and ion implantation is performed on the rear surface to form a collector electrode 12 and a collector electrode metal 13.

Example Two

The IGBT device according to the second embodiment has the following characteristics in addition to the first embodiment.

In implementation, the preset working voltage of the IGBT device is greater than or equal to $10\% \times BV$ and less than or equal to $80\% \times BV$, and BV is the breakdown voltage of the IGBT device.

The preset working voltage of the IGBT device is greater than or equal to $10\% \times BV$ and less than or equal to $80\% \times BV$, that is, the preset working voltage range of the IGBT device is very wide. The reason why the wide range of the preset working voltage of the IGBT device according to the embodiment of the present disclosure can be realized is that when the actual working voltage of the IGBT device is within the preset working voltage range, whether it is a high voltage or a low voltage, when the IGBT device is turned off, the electrical field can be rapidly broadened downward, and the minority carriers stored in the drift region and the electrical field transition layer are quickly depleted, that is, the electrical field transition layer can be completely depleted. However, due to the high doping concentration, the electrical field termination layer hardly stores minority carriers. As a result, the tail current becomes very small or close to zero. In this way, the IGBT device of the embodiment of the present disclosure realizes that the tail current is no longer related to the actual working voltage. In conventional super-junction devices, the tail current is related to the actual working voltage of super-junction devices. The smaller the actual working voltage, the greater the tail current. Therefore, compared with the conventional super-junction structure, the IGBT device of the embodiment of the present disclosure can be used at both high voltage within the preset working voltage range and low voltage within the preset working voltage range, and even under the low voltage condition, there is no tail current, and the turn-off loss is small.

Specifically, the preset working voltage of the IGBT device is greater than or equal to 10% × BV and less than or equal to 80% × BV, that is, the minimum preset working voltage of the IGBT device is 10% × BV, and the maximum preset working voltage of the IGBT device is 80% × BV.

Specifically, the preferable value range of the preset working voltage of the IGBT device is greater than or equal to 60% × BV and less than or equal to 70% × BV.

The actual working voltage of the IGBT device is greater than or equal to 60% × BV and less than or equal to 70% × BV, and the working state of the IGBT device is relatively stable.

In the description of the present disclosure, it should be understood that the orientation or positional relationship indicated by the terms "front", "rear", "head", "tail", etc. is based on the orientation or positional relationship shown in the drawings, and is only for the convenience and simplification of the description of the present disclosure, and does not indicate or imply that the referred device or element must have a specific orientation, be constructed and operate in a specific orientation, and therefore cannot be construed as a limitation of the present disclosure.

Furthermore, the terms "first" and "second" are for descriptive purposes only and are not to be understood as indicating or implicitly indicating relative importance or the number of technical features indicated. Thus, a feature defined as "first" or "second" may explicitly or implicitly include one or more of the features. In the description of the present disclosure, "a plurality" means at least two, such as two, three, etc., unless specifically defined otherwise.

In this disclosure, unless otherwise explicitly specified and defined, terms such as "mount" and "connect" are to be understood broadly; Taking connection as an example, it can be directly connected or indirectly connected through an intermediate medium, and it can be the internal connection of two elements or the interaction of two elements. Those skilled in the art can understand the specific meanings of the above-mentioned terms in the present disclosure according to the specific circumstances.

Although some alternative embodiments of the present disclosure have been described, additional changes and modifications may be made to these embodiments once those skilled in the art become aware of the basic inventive concepts. Accordingly, the appended claims are intended to be construed as including some alternative embodiments and all alterations and modifications falling within the scope of the present disclosure.

It will be apparent that those skilled in the art can make various changes and modifications to the present disclosure without departing from the spirit and scope of the present disclosure. Thus, the present disclosure is intended to include such modifications and variations to the extent that they fall within the scope of the claims of the present disclosure and their equivalents.

**Claims**

1. An IGBT device, **characterized in that**, comprising:

   a collector electrode (12) of a first doping type;
   an electrical field termination layer (11) of a second doping type, formed above the collector electrode;
   an electrical field transition layer (1) of the second doping type, formed above the electrical field termination layer;
   a drift region (2) of the second doping type, formed above the electrical field transition layer; and
   a plurality of pillar regions (3) of the first doping type, formed inside the drift region and arranged at intervals along a vertical withstand voltage direction;
   a well region (7) of the first doping type, formed above the drift region;
   wherein a doping concentration of the electrical field transition layer is less than a doping concentration of the electrical field termination layer, and the drift region and the electrical field transition layer accumulate minority carriers by conductance modulation effect respectively;
   wherein in case where the IGBT device is turned off, the electrical field transition layer is completely depleted, an electrical field decreases at the electrical field transition layer and decreases to 0 at the electrical field termination layer, and the electrical field decreases smoothly from top to bottom at an interface position between the electrical field transition layer and the electrical field termination layer.

2. The IGBT device according to claim 1, wherein a slope of an electrical field on a lower surface of the electrical field transition layer $T_{\text{transition layer lower surface}}$ and a slope of an electrical field on an upper surface of the electrical field termination layer $T_{\text{termination layer upper surface}}$ satisfy relationship of:

$$(T_{\text{termination layer upper surface}} - T_{\text{transition layer lower surface}}) / T_{\text{termination layer upper surface}} \leq 10\%.$$

3. The IGBT device according to claim 1, wherein a doping concentration of the lower surface of the electrical field transition layer $R_{\text{transition layer lower surface}}$ and a doping concentration of the upper surface of the electrical field termination layer $R_{\text{termination layer lower surface}}$ satisfy relationship of:

$$(R_{\text{termination layer upper surface}} - R_{\text{transition layer lower surface}}) / R_{\text{termination layer upper surface}} \leq 10\%.$$

4. The IGBT device according to claim 3, wherein the doping concentration of the electrical field transition layer gradually increases from an upper surface to the lower surface of the electrical field transition layer.

5. The IGBT device according to claim 4, wherein a doping of the electrical field transition layer is a linearly changing doping or a doping of the electrical field transition layer is a semi-normal distribution.

6. The IGBT device according to any one of claims 1 to 5, wherein a total charge $Q_{\text{total}}$ of the electrical field transition layer is less than or equal to k% $\times$ Ec/$\varepsilon$s;
wherein k% is a percentage of an electrical field strength to a critical breakdown electrical field strength under a condition of minimum preset working voltage of the IGBT device, Ec is the critical breakdown field strength of the IGBT device with a Si substrate, and $\varepsilon$s is a dielectric constant of the IGBT device with the Si substrate.

7. The IGBT device according to claim 6, wherein in case where the doping of the electrical field transition layer is linearly changing doping, the total charge $Q_{\text{total}}$ of the electrical field transition layer and a thickness Wp of the electrical field transition layer satisfy relationship of:

$$Q_{\text{total}} = q \times G \times Wp^2 / 2;$$

wherein q is a charge amount of one single electron and G is a slope of linearly changing doping.

8. The IGBT device according to claim 6, wherein a lower end of the pillar region (3) and a lower end of the drift region (2) are even, and the lower end of the pillar region (3) and the lower end of the drift region (2) are respectively connected to an upper surface of the electrical field transition layer (1).

9. The IGBT device according to claim 8, further comprising:

an epitaxial layer (4) of the second doping type formed above the drift region (2) and below the well region (7);
wherein an upper end of the pillar region (3) and an upper end of the drift region (2) are even, and the upper end of the pillar region (3) and the upper end of the drift region (2) are respectively connected with a lower surface of the epitaxial layer.

10. The IGBT device according to claim 9, further comprising:

a collector electrode metal (13), formed below the collector (12);
a gate trench, extended downward from an upper surface of the well region (7) into the epitaxial layer (4);
a gate oxide layer (5), formed in the gate trench;
a gate electrode (6), formed on the gate oxide layer (5) and even with an upper surface of the well region (7);
an emitter electrode (8) of the second doping type, downward from the upper surface of the well region (7), and the emitter electrode (8) is shallower in depth than the well region (7);
a dielectric layer (9), covering the gate electrode and the gate oxide layer and partially covering the emitter electrode (8); and
an emitter electrode metal (10), formed above the emitter electrode (8) and the dielectric layer (9);
wherein the dielectric layer (9) insulates the gate electrode and the emitter electrode metal.

Fig. 1

Fig. 2

Fig. 3

Fig. 4

## INTERNATIONAL SEARCH REPORT

| International application No. |
|---|
| **PCT/CN2023/102567** |

**A. CLASSIFICATION OF SUBJECT MATTER**

H01L29/06(2006.01)i; H01L29/739(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNTXT, ENTXTC, ENTXT, IEEE, CNKI: 华太电子, 千屹芯科技, 祁金伟, 刘倩, 张耀辉, IGBT, 双极, 晶体管, 绝缘栅, 超结, 场, 截止, 阻止, 停止, 终止, 过渡, 亚层, 子层, 电导调制, 零, 0, 电力线, 平滑, 斜率, bipolar, transistor, insulat+, gate, super, junction, electric, field, stop+, sub, terminat+, conduct, modulat+, zero, end+, smooth+, slope

**C. DOCUMENTS CONSIDERED TO BE RELEVANT**

| Category* | Citation of document, with indication, where appropriate, of the relevant passages | Relevant to claim No. |
|---|---|---|
| Y | CN 113644123 A (HUAWEI TECHNOLOGIES CO., LTD.) 12 November 2021 (2021-11-12) description, paragraphs [0060]-[0138], and figures 2-8 | 1 |
| Y | CN 114300528 A (SHENZHEN QIANYIXIN TECHNOLOGY CO., LTD.) 08 April 2022 (2022-04-08) description, paragraphs [0046]-[0089], and figures 2-13 | 1 |
| A | CN 104637994 A (SHANGHAI HUAHONG GRACE SEMICONDUCTOR MANUFACTURING CORP.) 20 May 2015 (2015-05-20) entire document | 1-10 |
| A | CN 106298898 A (SEMICONDUCTOR MANUFACTURING INTERNATIONAL (SHANGHAI) CORP.) 04 January 2017 (2017-01-04) entire document | 1-10 |
| A | CN 113471273 A (BYD SEMICONDUCTOR CO., LTD.) 01 October 2021 (2021-10-01) entire document | 1-10 |
| A | US 2022254877 A1 (HUAWEI TECHNOLOGIES CO., LTD.) 11 August 2022 (2022-08-11) entire document | 1-10 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 September 2023** | **12 September 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/102567**

| Patent document cited in search report | | | Publication date (day/month/year) | Patent family member(s) | | | Publication date (day/month/year) |
|---|---|---|---|---|---|---|---|
| CN | 113644123 | A | 12 November 2021 | US | 2022416063 | A1 | 29 December 2022 |
| | | | | EP | 4113624 | A1 | 04 January 2023 |
| | | | | JP | 2023007491 | A | 18 January 2023 |
| CN | 114300528 | A | 08 April 2022 | None | | | |
| CN | 104637994 | A | 20 May 2015 | None | | | |
| CN | 106298898 | A | 04 January 2017 | None | | | |
| CN | 113471273 | A | 01 October 2021 | WO | 2021197194 | A1 | 07 October 2021 |
| | | | | US | 2023015515 | A1 | 19 January 2023 |
| | | | | EP | 4131420 | A1 | 08 February 2023 |
| US | 2022254877 | A1 | 11 August 2022 | JP | 2022121395 | A | 19 August 2022 |
| | | | | EP | 4040501 | A1 | 10 August 2022 |
| | | | | CN | 113054010 | A | 29 June 2021 |

Form PCT/ISA/210 (patent family annex) (July 2022)